# EUROPEAN PATENT APPLICATION

(11) **EP 4 765 308 A1**
(43) Date of publication of application: **24.06.2026**
(21) Application number: 25219753.8
(22) Date of filing: 01.12.2025
(51) Int. Cl.: H01M 10/42, H01M 10/44, H01M 10/48

(54) **METHOD AND APPARATUS OF ESTIMATING SALT CONCENTRATION IN ELECTROLYTE SOLUTION OF SECONDARY BATTERY**

(30) Priority: 17.12.2024 JP 2024221122
(71) Applicant: Prime Planet Energy & Solutions, Inc., Chuo-ku, Tokyo 103-0022 (JP)
(72) Inventor: KUZUBA, Mitsuhiro, Tokyo,, 103-0022, (JP)
(74) Representative: Kuhnen & Wacker Patent- und Rechtsanwaltsbüro PartG mbB

(57) **Abstract**

A method of estimating a salt concentration in an electrolyte solution of a secondary battery (1) includes: a capacity acquiring step S1 of acquiring a capacity of a secondary battery (1) that is to be an estimation object; a discharging time acquiring step S2 of acquiring a discharging time when the secondary battery (1) is discharged under a predetermined condition; and a salt concentration estimating step S3 of estimating the salt concentration in the electrolyte solution of the secondary battery (1) based on the acquired capacity of the secondary battery (1), the acquired discharging time, and a table recording a relationship between the capacity, the discharging time, and the salt concentration in the electrolyte solution of the secondary battery (1), related to the secondary battery (1) that is to be the estimation object.

## Description

### TECHNICAL FIELD

The present disclosure relates to a method and apparatus of estimating a salt concentration in an electrolyte solution of a secondary battery.

### BACKGROUND

JP 2018-073777 A, for example, discloses a control system for a lithium-ion secondary battery that includes a detection device for detecting the temperature, current, and voltage of a lithium-ion secondary battery, and a control device. It is stated that in such a control system, when an estimated value of the amount of lithium deposition is greater than a predetermined value, the lithium-ion secondary battery is not used.

### SUMMARY

According to a study by the present inventor, it was found that the salt concentration in the electrolyte solution of a secondary battery may affect the characteristics of the secondary battery such as resistance to the deterioration in high current charging and discharging. Therefore, further development is demanded of the technique that is able to estimate the salt concentration in the electrolyte solution of a secondary battery.

A salt concentration estimation method disclosed herein for an electrolyte solution of a secondary battery includes a capacity acquiring step of acquiring a capacity of a secondary battery that is to be an estimation object. The salt concentration estimation method includes a discharging time acquiring step of acquiring a discharging time when the secondary battery is discharged under a predetermined condition. The salt concentration estimation method includes a salt concentration estimating step of estimating the salt concentration in the electrolyte solution of the secondary battery based on the acquired capacity of the secondary battery, the acquired discharging time, and a table recording a relationship between the capacity, the discharging time, and the salt concentration in the electrolyte solution of the secondary battery, related to the secondary battery that is to be the estimation object. According to the present disclosure, it is possible to provide a method that is capable of estimating the salt concentration in the electrolyte solution of a secondary battery.

A salt concentration estimation apparatus disclosed herein for an electrolyte solution of a secondary battery is configured to cause a computer to execute a capacity acquiring process of acquiring a capacity of a secondary battery that is to be an estimation object. The salt concentration estimation apparatus is configured to cause the computer to execute a discharging time acquiring process of acquiring a discharging time when the secondary battery is discharged under a predetermined condition. The salt concentration estimation apparatus is configured to cause the computer to execute a salt concentration estimating process of estimating the salt concentration in the electrolyte solution of the secondary battery based on the acquired capacity of the secondary battery, the acquired discharging time, and a table recording a relationship between the capacity, the discharging time, and the salt concentration in the electrolyte solution of the secondary battery, related to the secondary battery that is to be the estimation object. According to the present disclosure, it is possible to provide an apparatus that is capable of estimating the salt concentration in the electrolyte solution of a secondary battery.

### BRIEF DESCRIPTION OF THE DRAWINGS

Fig. 1 is a flowchart illustrating a salt concentration estimation method in an electrolyte solution of a secondary battery according to one embodiment of the present disclosure.
Fig. 2 is a schematic view illustrating a salt concentration estimation apparatus in an electrolyte solution of a secondary battery according to one embodiment of the present disclosure.
Fig. 3 is a first matrix chart illustrating one example of a capacity estimation map for a secondary battery.
Fig. 4 is a second matrix chart illustrating another example of the capacity estimation map for a secondary battery.
Fig. 5A is a first graph showing the relationship between reach time and salt concentration of a secondary battery when the full charge capacity is 100%.
Fig. 5B is a second graph showing the relationship between reach time and salt concentration of the secondary battery when the full charge capacity is 90%.
Fig. 5C is a third graph showing the relationship between reach time and salt concentration of the secondary battery when the full charge capacity is 80%.
Fig. 6 is a matrix chart illustrating one example of a salt concentration estimation map for the electrolyte solution of a secondary battery.
Fig. 7 is a schematic view illustrating a salt concentration estimation apparatus in an electrolyte solution of a secondary battery according to another embodiment of the present disclosure.
Fig. 8 is a flowchart illustrating a salt concentration estimation method in the electrolyte solution of the secondary battery according to the other embodiment of the present disclosure.

### DETAILED DESCRIPTION

Hereinbelow, embodiments of the technology according to the present disclosure will be described with reference to the drawings. It should be noted, however, that the embodiments illustrated herein are, of course, not intended to limit the present disclosure. The drawings are schematic illustrations, and do not necessarily reflect any actual product. The features and components that exhibit the same effects are designated by the same reference symbols as appropriate, and the description thereof will not be repeated as appropriate. It should be noted that matters that are other than those specifically described in this description but are required to carry out the technology disclosed herein (such as, for example, the general configurations of secondary batteries that are not characterized by the present disclosure and the methods of measuring the capacity and discharging time of a secondary battery) may be understood as design considerations for a skilled person in the art based on the prior art in the relevant field. The technology disclosed herein may be implemented based on the contents disclosed in this description and the common general technical knowledge in the related field. It should be noted that the recitation of numerical ranges in the present description, such as "A to B", is meant to include any values between the upper limits and the lower limits, inclusive, that is, "greater than or equal to A to less than or equal to B". The phrase "A to B" is meant to include "greater than A" and "less than B".

In the following description, a method of estimating a salt concentration in an electrolyte solution of a secondary battery 1 may be referred to simply as a "salt concentration estimation method". Also, an apparatus of estimating a salt concentration in the electrolyte solution of the secondary battery 1 may be referred to simply as a "salt concentration estimation apparatus".

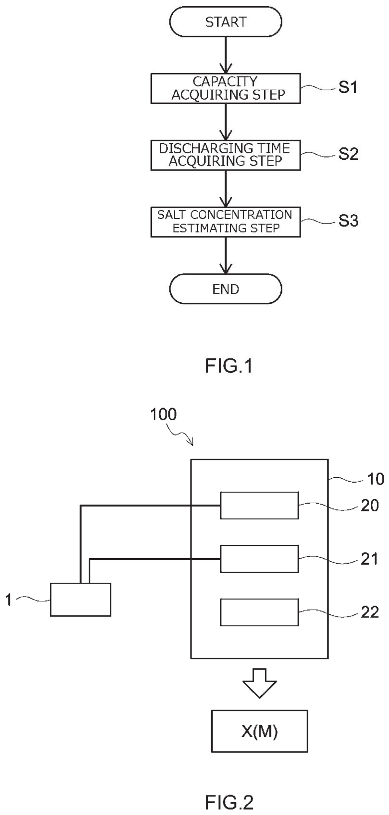

Herein, Fig. 1 is a flowchart illustrating the salt concentration estimation method in the electrolyte solution of the secondary battery 1 according to one embodiment. The method of estimating a salt concentration in an electrolyte solution of a secondary battery includes, as illustrated in Fig. 1, a capacity acquiring step S1, a discharging time acquiring step S2, and a salt concentration estimating step S3. Fig. 2 is a schematic view illustrating a salt concentration estimation apparatus 100. The salt concentration estimation apparatus 100 includes a computer 10. Such a method of estimating a salt concentration in an electrolyte solution of a secondary battery is embodied by the computer 10.

Herein, the computer 10 may include a memory storage device (such as a memory) and an arithmetic unit (such as a CPU). Various processes of the controller may be implemented as processing modules executed by predetermined programs. Various functions of the computer 10 may be implemented appropriately by cooperative combinations of physical components and control operations based on the results of computation performed according to predetermined programs. The computer 10 may be one in which a plurality of computers cooperate with each other. For example, when the computer 10 is data-communicably connected to an external computer via, for example, LAN cables, the Internet, or the like, the processes of the computer 10 may be performed in cooperation with such an external computer. For example, the information, or a portion of the information, to be stored in the computer 10 may be stored in the external computer, and the process, or a portion of the process, to be executed by the computer 10 may be executed by the external computer.

### Salt Concentration Estimation Apparatus 100

The salt concentration estimation apparatus 100 is an apparatus for estimating the salt concentration in the electrolyte solution of a secondary battery 1. As illustrated in Fig. 2, the salt concentration estimation apparatus 100 includes a capacity acquisition processing unit 20, a discharging time acquisition processing unit 21, and a salt concentration estimation processing unit 22. Each of the capacity acquisition processing unit 20, the discharging time acquisition processing unit 21, and the salt concentration estimation processing unit 22 is embodied by the computer 10.

As illustrated in Fig. 2, in the present embodiment, the secondary battery 1 is mounted in an electrically powered vehicle. Although the type of the electrically powered vehicle is not particularly limited herein, examples may include electric bicycles, electric motorcycles, electric vehicles, electric trains, and the like. Examples of the electric vehicles include plug-in hybrid electric vehicles (PHEVs), hybrid electric vehicles (HEVs), battery electric vehicles (BEVs), and the like. Herein, an example is shown of the salt concentration estimation apparatus 100 for the secondary battery 1 mounted in an electrically powered vehicle. The salt concentration estimation apparatus 100 is not limited to those used for electrically powered vehicles but may be used for, for example, electrically powered watercrafts and the like.

The secondary battery 1 means a battery in which charging and discharging are performed by means of migration of charge carriers through an electrolyte (electrolyte solution herein) between a pair of electrodes (positive electrode and negative electrode). The secondary battery 1 herein is a non-aqueous electrolyte secondary battery. Examples of the secondary battery 1 include a lithium-ion secondary battery, a sodium-ion secondary battery, a nickel-metal hydride battery, a nickel-cadmium battery, or the like. Although the present embodiment describes the secondary battery 1 as a lithium-ion secondary battery, it is not intended to limit the type of secondary battery to the lithium ion secondary battery.

Although not shown in detail, the secondary battery 1 includes a case, an electrode body housed in the case, and an electrolyte solution housed in the case. The shape of the case is not limited to any particular shape, and may be, for example, a flat rectangular parallelepiped shape or a cylindrical shape. The electrode body includes, for example, a positive electrode (positive electrode sheet) serving as a positive electrode element, a negative electrode (negative electrode sheet) serving as a negative electrode element, and a separator interposed between the positive electrode sheet and the negative electrode sheet. The type of the electrode body is not limited to any particular type, and may be, for example, a stacked electrode body or a wound electrode body.

The electrolyte solution may contain, for example, a supporting salt and a non-aqueous solvent. The electrolyte solution may be, for example, a non-aqueous electrolyte solution in which a supporting salt is dissolved in a non-aqueous solvent. Examples of the non-aqueous solvent include carbonate-based solvents, such as ethylene carbonate, dimethyl carbonate, and ethyl methyl carbonate. These may be used either alone or in combination of two or more of them. Examples of the supporting salt include lithium salts such as LiPF₆, LiBF₄, and lithium bis(fluorosulphonyl)imide (LiFSI). These may be used either alone or in combination of two or more of them. The concentration of the supporting salt may be, but is not particularly limited to, 0.6 mol/L to 1.8 mol/L (preferably 0.7 mol/L to 1.5 mol/L), for example. The electrolyte solution may contain various types of addition agents including: film forming agents such as oxalato complex and vinylene carbonate (VC), gas generating agents such as biphenyl (BP) and cyclohexylbenzene (CHB), and thickening agents. Note that in the present description, the phrase "salt concentration in the electrolyte solution of a secondary battery" means the concentration of the supporting salt (for example, ion concentration) in the electrolyte solution of the secondary battery. When the electrolyte solution contains two or more kinds of supporting salts, the phrase means the total value of the concentrations of them. For example, in the present embodiment, the salt concentration in the electrolyte solution of the secondary battery 1 means the concentration of the lithium salt (lithium ion concentration) in the electrolyte solution. Such a salt concentration may be measured with, for example, a commercially available ion meter. Note that in the following description, the notation "mol/L" may be denoted simply as **"M".**

### Capacity Acquisition Processing Unit 20

The capacity acquisition processing unit 20 is configured to execute a process of acquiring the capacity of the secondary battery 1 that is to be the estimation object. The capacity acquisition processing unit 20 is configured to acquire the capacity of the secondary battery 1 by, for example, a method of estimating the capacity of the secondary battery 1 from the number of years of use and the temperature history, or a method of estimating the capacity of the secondary battery 1 from the interval capacity during charging. The capacity acquisition processing unit 20 may be configured to be able to receive, for example, information such as the use history, temperature history, and charging time from the secondary battery 1. The method of acquiring the capacity that is implemented by the capacity acquisition processing unit 20 will be described further in detail later.

### Discharging Time Acquisition Processing Unit 21

The discharging time acquisition processing unit 21 is configured to execute a process of acquiring the discharging time when the secondary battery 1 is discharged under predetermined conditions. Specifically, the discharging time acquisition processing unit 21 herein is configured to acquire the discharging time when the secondary battery 1 is discharged under later-described conditions. In the present embodiment, the discharging time acquisition processing unit 21 is configured to acquire the discharging time when the secondary battery 1 is discharged under predetermined conditions during use of an electrically powered vehicle. The discharging time acquisition processing unit 21 is configured to be able to receive, for example, information such as the discharging time from the secondary battery 1.

### Salt Concentration Estimation Processing Unit 22

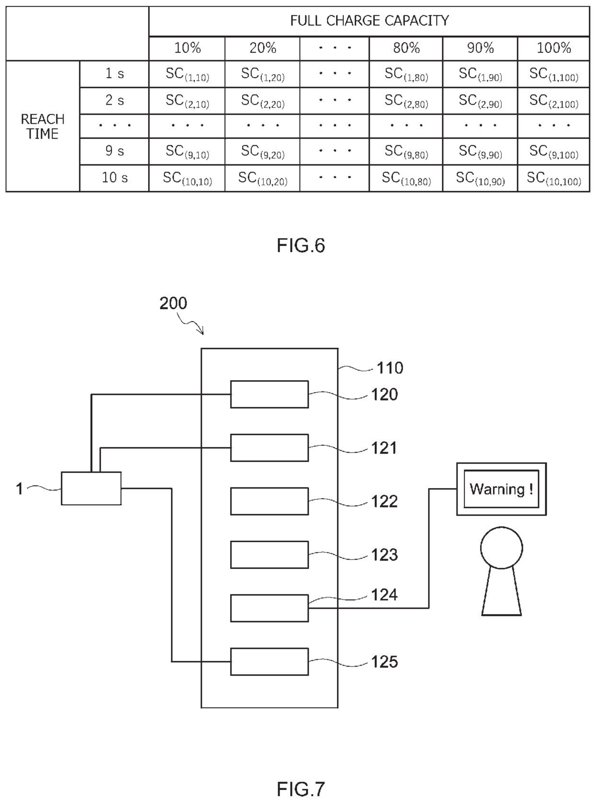

The salt concentration estimation processing unit 22 executes a process of estimating the salt concentration in the electrolyte solution of the secondary battery 1 based on the acquired capacity of the secondary battery 1, the acquired discharging time, and a table (hereinafter also referred to as a "map") that records a relationship between the capacity, the discharging time, and the salt concentration in the electrolyte solution of the secondary battery 1 related to the secondary battery 1 that is to be the estimation object. Specifically, the salt concentration estimation processing unit 22 refers to the map as shown in Fig. 6 based on the capacity of the secondary battery 1 acquired by the capacity acquisition processing unit 20 and the discharging time of the secondary battery 1 acquired by the discharging time acquisition processing unit 21. Then, the salt concentration estimation processing unit 22 acquires a corresponding salt concentration in the map as the salt concentration in the electrolyte solution of the secondary battery 1 at the time of measurement. In this manner, the salt concentration estimation apparatus 22 is able to estimate the salt concentration in the electrolyte solution of the secondary battery 1.

In a preferred embodiment, the discharging time acquisition processing unit 21 acquires the discharging time when the secondary battery 1 is discharged with the SOC being at least 50%. Although the details will be discussed later in the section titled "Salt Concentration Estimation Method" below, such a configuration allows the discharging time to be acquired more easily.

In a preferred embodiment, the discharging time acquisition processing unit 21 acquires the discharging time when the secondary battery 1 is discharged under a temperature environment in which the average temperature is lower than or equal to -10°C. Although the details will be discussed later in the section titled "Salt Concentration Estimation Method" below, such a configuration makes it possible to suitably estimate the salt concentration in the electrolyte solution even when, for example, high current cannot be passed for the system.

Hereinafter, a salt concentration estimation method that is implemented by the salt concentration estimation apparatus 100 will be described. Herein, the description is provided together with the explanation about the salt concentration estimation apparatus 100 as appropriate. It should be noted that the following description is not intended to limit the salt concentration estimation method disclosed herein to the configuration described below. The steps described below may be performed in any order as long as the advantageous effects of the technology disclosed herein can be obtained. Moreover, additional steps other than the steps described below may be further added as necessary.

### Salt Concentration Estimation Method

Fig. 1 is a flowchart illustrating a salt concentration estimation method in the electrolyte solution of the secondary battery 1 according to one embodiment of the present disclosure. As illustrated in Fig. 1, the salt concentration estimation method according to the present embodiment includes a capacity acquiring step S1, a discharging time acquiring step S2, and a salt concentration estimating step S3. It should be noted that the present embodiment assumes estimation of the salt concentration in the electrolyte solution of the secondary battery 1 mounted in an electrically powered vehicle. Hereinbelow, each of the steps will be described.

### Capacity Acquiring Step S1

This step involves acquiring the capacity of the secondary battery 1 that is to be the estimation object. Various methods that can estimate the capacity degradation rate may be employed to acquire (estimate) the capacity of the secondary battery 1. There are various types of methods of estimating the capacity and estimating the capacity degradation rate of the secondary battery 1, and it is possible to employ an appropriate method. Hereinbelow, one example of the method of acquiring the capacity of the secondary battery 1 will be described. However, this is not intended to limit the method of acquiring the capacity of the secondary battery 1 to the following.

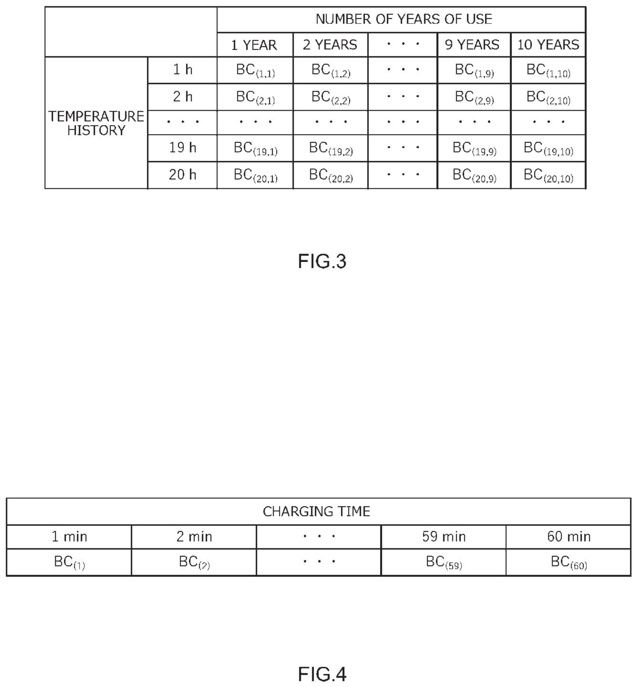

An example of the method of acquiring the capacity of the secondary battery 1 involves acquiring the capacity from the number of years of use and the temperature history of the secondary battery 1. Specifically, first, a map is prepared concerning the relationship between the number of years of use of the secondary battery 1, the temperature history of the secondary battery 1, and the capacity of the secondary battery 1. Here, Fig. 3 is a first matrix chart illustrating one example of a capacity estimation map for the secondary battery 1. The map shown in Fig. 3 is a preferable example of the map that is prepared in advance. Herein, the number of years of use in Fig. 3 may mean the number of years from the start of use of the secondary battery 1 to the start of capacity measurement of the secondary battery 1. Also, the temperature history of the secondary battery 1 may mean, for example, the total time in which the temperature of the secondary battery 1 was outside a predetermined temperature range within the number of years of use. Such a temperature range may be set to, but is not particularly limited to, for example, -30°C to 60°C (preferably -10°C to 40°C). In addition, for the capacity of the secondary battery 1, the full charge capacity of the secondary battery 1 is employed herein. Herein, the full charge capacity of the secondary battery 1 decreases over time in association with charging and discharging of the secondary battery 1. The term "the full charge capacity of the secondary battery 1" may mean the battery capacity that the secondary battery 1 charged to 100% state of charge (SOC), which is the maximum charge capacity, can deliver until it is completely discharged.

Note that in the present description, the term "SOC" means the state of charge. Specifically, the state of charge at which the operating voltage reaches the upper limit (i.e., the state at which the voltage does not increase any longer even when charging is continued) is defined to be SOC = 100%. On the other hand, the state of charge at which the operating voltage reaches the lower limit (i.e., the state at which the voltage does not decrease any longer even while discharging is continued) is defined to be SOC = 0%. Note that, for the specific means for measuring SOC, conventionally known measuring means may be employed without any particular restriction and it does not limit the technology disclosed herein in any way. Therefore, further description will not be made herein.

For example, in the map shown in Fig. 3, the number of years of use of secondary battery 1 is shown in increments of 1 year in the range of 1 year to 10 years. The temperature history of secondary battery 1 is shown in increments of 1 hour in the range of 1 hour to 20 hours. Also, the capacity of secondary battery 1 is shown as BC (Battery Capacity). The numerical values in parentheses following BC indicate (temperature history, number of years of use). The map shown in Fig. 3 can be created by, for example, preparing a plurality of secondary batteries 1 with different numbers of years of use and different temperature histories, and measuring the full charge capacity of each of them. It is also possible to create the map without actually preparing a plurality of secondary batteries 1 with different numbers of years of use and different temperature histories but by simulation based on past data. Herein, the full charge capacity of the secondary battery 1 may be measured by a conventionally known method. The measurement conditions for the full charge capacity may be set as appropriate depending on the type, dimensions, and the like of the secondary battery 1. Note that in the present embodiment, the full charge capacity is expressed as a percentage (%). Specifically, it indicates the percentage (%) of the full charge capacity of the secondary battery 1 at the time of measurement in relation to the value of the full charge capacity of the secondary battery 1 when unused being 100%.

In acquiring the capacity of the secondary battery 1 as described above, the salt concentration estimation apparatus 100 may operate in the following manner. Specifically, first, the capacity acquisition processing unit 20 provided in the salt concentration estimation apparatus 100 acquires the number of years of use and the temperature history of the secondary battery 1 from the secondary battery 1 mounted in an electrically powered vehicle. Next, the capacity acquisition processing unit 20 refers to the capacity estimation map (see Fig. 3) that is prepared in advance for the secondary battery 1 based on the number of years of use and temperature history acquired from the secondary battery 1. Then, the capacity acquisition processing unit 20 acquires a corresponding capacity in the capacity estimation map for the secondary battery 1 as the capacity of the secondary battery 1 at the time of measurement. In this manner, the capacity of the secondary battery 1 can be acquired.

Another example of the method of acquiring the capacity of the secondary battery 1 involves acquiring the capacity from the interval capacity during charging of the secondary battery 1. Herein, the term "interval capacity during charging of the secondary battery" means the capacity of the secondary battery that is estimated from the time required for charging the battery from a predetermined SOC to another predetermined SOC when charging the battery at a predetermined amount of current (which hereinafter may also be referred to as "charging time"). Specifically, first, a map is prepared in advance for the capacity of a secondary battery 1 and the charging time required for charging the secondary battery 1 with predetermined charging conditions. The predetermined charging conditions mean, for example, the SOC at the start of charging, the amount of charging current, and the SOC at the end of charging. Here, Fig. 4 is a second matrix chart illustrating another example of the capacity estimation map for the secondary battery 1. The map shown in Fig. 4 is a preferable example of the map that is prepared in advance. It is preferable that the SOC at the start of charging, the amount of charging current, and the SOC at the end of charging may be set as appropriate depending on the type of the secondary battery 1, the environment in which the secondary battery 1 is placed, or the like. In addition, for the capacity of the secondary battery 1, the full charge capacity of the secondary battery 1 is employed herein.

For example, Fig. 4 is a map when charging of the secondary battery 1 is performed with the SOC at the start of charging being set to 20%, the amount of charging current being set to 5 A, and the SOC at the end of charging being set to 80%. In the map shown in Fig. 4, the charging time of the secondary battery 1 is shown in increments of 1 minute in the range of 1 minute to 60 minutes. Also, the capacity of secondary battery 1 is shown as BC. The numerical values in parentheses following BC indicate the charging time. The map shown in Fig. 4 can be created by, for example, preparing a plurality of secondary batteries 1 with different full charge capacities, charging them under predetermined charging conditions, and measuring the charging time of each of them. It is also possible to create the map without actually preparing a plurality of secondary batteries 1 with different full charge capacities but by simulation based on past data.

In estimating the capacity of the secondary battery 1 as described above, the salt concentration estimation apparatus 100 may operate in the following manner. Specifically, first, the capacity acquisition processing unit 20 provided in the salt concentration estimation apparatus 100 acquires the charging time when the secondary battery 1 is charged under predetermined conditions from the secondary battery 1 mounted in an electrically powered vehicle. Next, the capacity acquisition processing unit 20 refers to the capacity estimation map (see Fig. 4) based on the charging time acquired from the secondary battery 1. Then, the capacity acquisition processing unit 20 acquires a corresponding capacity in the capacity estimation map for the secondary battery 1 as the capacity of the secondary battery 1 at the time of measurement. In this manner, the capacity acquisition processing unit 20 is able to acquire the capacity of the secondary battery 1.

### Discharging Time Acquiring Step S2

This step involves acquiring the discharging time when the secondary battery 1 is discharged under predetermined conditions. In this step, the secondary battery 1 is discharged under predetermined conditions, and the time until a predetermined voltage is reached is acquired as the discharging time. The present embodiment acquires the discharging time when the secondary battery 1 is discharged under predetermined conditions during use of an electrically powered vehicle.

The discharge conditions for the secondary battery 1 are not particularly limited as long as the advantageous effects of the technology disclosed herein can be obtained. The discharge conditions for the secondary battery 1 include the average temperature and average current during discharging, the SOC at the start of discharging, the voltage at the end of discharging, and the like. The term "average temperature during discharging" may mean, for example, the mean value of 5 or more points (for example, 10 points) of temperatures randomly sampled from the temperatures during discharging. Likewise, the term "average current during discharging" may mean, for example, the mean value of 5 or more points (for example, 10 points) of currents randomly sampled from the currents during discharging.

The average temperature during discharging may be, but is not particularly limited to, for example, lower than or equal to 30°C, lower than or equal to 25°C, lower than or equal to 20°C, even lower than or equal to 10°C, or lower than or equal to 0°C. Here, as discharging is performed at higher current or for longer time, for example, the salt on the electrode surface is more likely to dry out, and consequently, the droop of the discharge voltage curve resulting from the decrease of the salt concentration tends to appear more significantly. In addition, when the diffusion resistance is higher, the droop of the discharge voltage curve is more likely to occur. For example, when high current discharging or the like can be performed, the droop of the discharge voltage curve is observed easily, so the discharging time is acquired easily. However, for example, when high current cannot be passed for the system, the droop of the discharge voltage curve may not be observed easily, and consequently, the discharging time may not be acquired easily. In view of that, according to a study conducted by the present inventor, it was discovered that the salt diffusion is slower and the influence of the diffusion resistance resulting from the decrease in the salt concentration is accordingly greater under a low temperature environment than under a room temperature environment. That is, it was discovered that, for example, even when high current cannot be passed for the system, the discharging time can be acquired more easily under a low temperature environment than under a room temperature environment, provided that the same amount of current is passed. From the above discussion, it is preferable that the average temperature during discharging be lower than or equal to -10°C, more preferably lower than or equal to -20°C, from the viewpoint of acquiring the discharging time more easily, for example, even when high current cannot be passed for the system. In other words, it is preferable that in the discharging time acquiring step S2, the secondary battery 1 be discharged under a low temperature environment in which the average temperature is lower than or equal to -10°C to measure the discharging time. In addition, the lower limit of the average temperature during discharging may be higher than or equal to, for example, -40°C, or higher than or equal to -30°C.

Although not limited thereto, the average current during discharging is, for example, higher than or equal to 50 A. On the other hand, it is preferable that the average current during discharging be higher than or equal to 100 A, more preferably higher or equal to 200 A, or even higher than or equal to 300 A, from the viewpoint of acquiring the discharging time more easily. In addition, the upper limit of the average current during discharging is, for example, less than or equal to 500 A, or may be less than or equal to 400 A. In other words, it is preferable that in the discharging time acquiring step S2, the secondary battery 1 be discharged so that the average current during discharging is at least 100 A to measure the discharging time.

The SOC at the start of discharging may be, but is not particularly limited to, greater than or equal to 30%, or greater than or equal to 40%. Here, according to a study conducted by the present inventor, it was discovered that, when discharging is started from a low SOC, for example, the lower limit current (in other words, the minimum usable current restrained by the cell or the system) is reached easily because of the voltage drop resulting from direct current or reaction resistance. That is, it was discovered that, when discharging is started from a low SOC, it is difficult to perform high current discharging or long time discharging such that the diffusion resistance of the salt (or drying out of the salt) can be observed. Therefore, it is preferable that discharging be started from a high SOC, from the viewpoint of acquiring the discharging time easily. That is, it is preferable that the SOC at the start of discharging be higher than or equal to 50%, more preferably higher than or equal to 60% or higher than or equal to 70%, even more preferably higher than or equal to 80% or higher than or equal to 90% (may even be 100%). In other words, it is preferable that in the discharging time acquiring step S2, the secondary battery 1 be discharged from a high SOC condition in which the SOC is at least 50%, to measure the discharging time.

Although not particularly limited thereto, the voltage at the end of discharging is, for example, higher than or equal to 0.5 V, or may be higher than or equal to 1 V, or even higher than or equal to 1.5 V. On the other hand, it is preferable that the voltage at the end of discharging be higher than or equal to 2 V, more preferably higher or equal to 2.5 V, from the viewpoint of acquiring the discharging time easily. In addition, the upper limit of the voltage at the end of discharging is, for example, less than or equal to 5 V, or may be less than or equal to 4 V or less than or equal to 3 V. In other words, it is preferable that in the discharging time acquiring step S2, the secondary battery 1 be discharged so that the voltage at the end of discharging is at least 2 V to measure the discharging time.

In such measuring the discharging time of the secondary battery 1, the discharging time acquisition processing unit 21 provided in the salt concentration estimation apparatus 100 acquires the discharging time from the secondary battery 1 mounted in an electrically powered vehicle. It should be noted that the discharging under predetermined conditions as described above may be performed for, for example, an external load or the like. Examples of such an external load may include resistors, fans, heaters, and the like. Alternatively, the discharging time acquisition processing unit 21 may acquire, as the discharging time, data of an electrically powered vehicle during travelling when the above-described predetermined conditions are met. That is, the discharging time acquisition processing unit 21 may acquire, as the discharging time, data that satisfy the above-described predetermined conditions during travel of the electrically powered vehicle.

### Salt Concentration Estimating Step S3

This step involves estimating the salt concentration in the electrolyte solution of the secondary battery 1 based on the acquired capacity of the secondary battery 1, the acquired discharging time, and a table that records a relationship between the capacity, the discharging time, and the salt concentration in the electrolyte solution of the secondary battery 1 related to the secondary battery 1 that is to be the estimation object. Specifically, a map is prepared that records the relationship between the capacity of the secondary battery 1, the discharging time of the secondary battery 1, and the salt concentration in the electrolyte solution of the secondary battery 1 in advance.

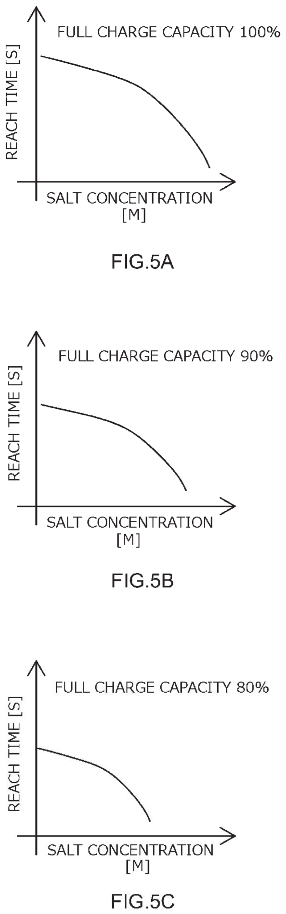

The just-mentioned map may be prepared using a table (matrix) as described in the following. Here, Figs. 5A, 5B, and 5C are a first graph, a second graph, and a third graph, respectively, that show the relationship between discharging time and salt concentration according to one embodiment. Fig. 6 is a matrix chart illustrating one example of a salt concentration estimation map for the electrolyte solution of the secondary battery 1.

First, the graphs shown in Figs. 5A, 5B, and 5C will be described. The horizontal axis and the vertical axis in each graph represent salt concentration and reach time (discharging time), respectively. The respective graphs show graphs at a full charge capacity of 100%, 90%, and 80%, respectively. Here, the secondary battery 1 with a full charge capacity of 100% means that no capacity degradation of the secondary battery 1 has occurred yet. Also, the secondary battery 1 with a full charge capacity of 90% means that the capacity degradation has occurred by 10% in association with the use of the secondary battery 1. Further, the secondary battery 1 with a full charge capacity of 80% means that the capacity degradation has occurred by 20% in association with the use of the secondary battery 1.

Next, a specific method of obtaining each of the graphs will be described. In the following, a method of obtaining the graph shown in Fig. 5B is described as an example. Note that Figs. 5A, 5B, and 5C show graphs when measurement was performed using a non-aqueous lithium ion secondary battery (lithium nickel cobalt manganese oxide - graphite, capacity: 4 Ah) as the secondary battery 1.

First, a plurality of secondary batteries 1 having different salt concentrations in the electrolyte solution are prepared. Although not particularly limited thereto, it is preferable that the number of samples of secondary batteries 1 with different salt concentrations may be 3 or more, more preferably 5 or more, even more preferably 10 or more, from the viewpoint of obtaining graphs with higher accuracy. It is preferable that the upper limit of the number of samples of secondary batteries 1 with different salt concentrations be less than or equal to 20, or less than or equal to 15, from the viewpoint of cost or the like.

For example, in the present embodiment, 6 samples of the secondary battery 1 are prepared, in which the salt concentrations in the electrolyte solutions are 0.4 M, 0.6 M, ..., and 1.4 M. Next, for the prepared plurality of secondary batteries 1, capacity degradation is caused to advance by performing high current charging and discharging, for example. Herein, the capacity degradation of the secondary batteries 1 is advanced so that the full charge capacity reaches 90%. Subsequently, each of the secondary batteries 1 that has reached a full charge capacity of 90% is discharged under predetermined conditions. For example, in the present embodiment, the discharge conditions are as follows: average temperature during discharging: 25°C, average current during discharging: 300 A, SOC at the start of discharging: 50%, and voltage at the end of discharging: 2.5 V. Then, for each of the secondary batteries 1, the discharging time at which the voltage has reached 2.5 V is acquired as the reach time. Then, finally, the secondary batteries 1 are disassembled, and the respective salt concentrations in the respective electrolyte solutions are obtained. Then, the graph shown in Fig. 5B can be obtained by plotting the reach time and salt concentrations that are obtained in the above-described manner. The graphs shown in Figs. 5A and 5C may also be obtained as in the manner described above.

Note that in the graphs of Figs. 5A, 5B, and 5C, reach time is shorter from the top toward the bottom along the vertical axis. Also, in the horizontal axis of each of the graphs, salt concentration is lower from the left toward the right along the horizontal axis. As seen from each of the graphs, when the salt concentration in the electrolyte solution decreases, the reach time to a predetermined voltage (2.5 V herein) becomes shorter. Although this reach time becomes shorter even with a normal decrease in the full charge capacity, the reach time is shorter when the salt concentration decreases, even with the same full charge capacity.

In the present embodiment, the graphs for full charge capacities of 70%, 60%, 50%, 40%, 30%, 20%, and 10% are obtained likewise, in addition to the graphs of Figs. 5A, 5B, and 5C. Then, a map is prepared, as illustrated in Fig. 6, for the relationship between the capacity (full charge capacity herein) of the secondary battery 1, discharging time (reach time), and the salt concentration in the electrolyte solution of the secondary battery 1. Herein, in the map, the salt concentration in the electrolyte solution of the secondary battery 1 is indicated as SC (Salt Concentration). The numerical values in parentheses following SC indicate (reach time, full charge capacity), respectively.

In estimating the salt concentration in the electrolyte solution of the secondary battery 1 as described above, the salt concentration estimation apparatus 100 may operate in the following manner. Specifically, first, the salt concentration estimation processing unit 22 provided in the salt concentration estimation apparatus 100 prepares a map (see Fig. 6) in advance that is created for the relationship between the capacity of the secondary battery 1, the discharging time of the secondary battery 1, and the salt concentration in the electrolyte solution of the secondary battery 1. Then, the salt concentration estimation processing unit 22 refers to the map based on the capacity of the secondary battery 1 acquired by the capacity acquisition processing unit 20 and the discharging time acquired by the discharging time acquisition processing unit 21, to obtain the estimate value of the salt concentration of the secondary battery 1. Note that Fig. 6 merely illustrates an example of the map used herein. The map prepared herein may be one in which the relationship between the capacity of the secondary battery 1, the discharging time, and the salt concentration in the electrolyte solution related to the secondary battery 1 that is the estimation object is recorded in a predetermined table (matrix).

As has been described above, the salt concentration estimation method according to the present embodiment is able to estimate the salt concentration in the electrolyte solution of a secondary battery 1 using the capacity of the secondary battery 1 calculated in the capacity acquiring step S1 and the discharging time measured in the discharging time acquiring step S2. As a result of a study conducted by the present inventor, it was discovered that the discharging time varies for each capacity of the secondary batteries 1 when the secondary batteries 1 are discharged under predetermined conditions. Focusing on this fact, the salt concentration in the electrolyte solution of the secondary battery 1 is estimated based on the acquired capacity of the secondary battery 1, the acquired discharging time, and a table that records the relationship between the capacity, the discharging time, and the salt concentration in the electrolyte solution of the secondary battery 1 concerning the secondary battery 1 that is to be the estimation object, so the salt concentration in the electrolyte solution can be estimated accurately. By identifying the current salt concentration in the electrolyte solution of the secondary battery 1 in this manner, it is possible to prevent various problems that may occur due to the decrease of the salt concentration in the electrolyte solution (such as, for example, freezing of the electrolyte solution under low temperature, degradation in input/output power, decrease in resistance to deterioration due to high current charging and discharging, and increase in errors in estimating the remaining driving range), which are difficult to find from, for example, the estimation of the amount of Li deposition. Such a salt concentration estimation can be performed by, for example, the salt concentration estimation apparatus 100 provided with the computer 10 including the capacity acquisition processing unit 20, the discharging time acquisition processing unit 21, and the salt concentration estimation processing unit 22.

In addition, in the present embodiment, the secondary battery 1 is As illustrated in Fig. 2, in the present embodiment, the secondary battery 1 is mounted in an electrically powered vehicle. The discharging time acquiring step S2 acquires the discharging time when the secondary battery 1 is discharged under predetermined conditions during use of the electrically powered vehicle. Thus, according to the technology of the present disclosure, it is possible to estimate the salt concentration in the electrolyte solution of the secondary battery 1 even when it is used in the electrically powered vehicle.

Hereinabove, an embodiment (first preferred embodiment) of the technology proposed herein has been described. It should be understood, however, that the foregoing description is merely exemplary and is not intended to limit the scope of the claims. Various modifications and alterations of the above-described examples illustrated in the foregoing description are also within the scope of the disclosure as defined by the appended claims.

### Other Embodiments

For example, Fig. 7 is a schematic view illustrating a salt concentration estimation apparatus 200 according to another embodiment (second embodiment), for an electrolyte solution of a secondary battery 1. As illustrated in Fig. 7, the salt concentration estimation apparatus 200 according to the second embodiment includes a computer 110. The computer 110 includes a capacity acquisition processing unit 120, a discharging time acquisition processing unit 121, a salt concentration estimation processing unit 122, a determination processing unit 123, a notification processing unit 124, and a control processing unit 125. The configurations of the capacity acquisition processing unit 120, the discharging time acquisition processing unit 121, and the salt concentration estimation processing section 122 may be the same as those of the capacity acquisition processing unit 20, the discharging time acquisition processing unit 21, and the salt concentration estimation processing section 22 described above, and therefore, no further detailed description thereof is provided.

The determination processing unit 123 provided in the computer 110 determines whether or not the salt concentration in the electrolyte solution of the secondary battery 1 that is estimated by the salt concentration estimation processing unit 122 is less than or equal to a predetermined salt concentration. When the determination processing unit 123 determines that the salt concentration in the electrolyte solution of the secondary battery 1 is less than or equal to the predetermined salt concentration, the notification processing unit 124 notifies the user of the decrease of the salt concentration. When the determination processing unit 123 determines that the salt concentration in the electrolyte solution of the secondary battery 1 is less than or equal to the predetermined salt concentration, the control processing unit 125 corrects battery control values for the secondary battery 1 (such as, for example, input/output values) to appropriate values. Hereinafter, a salt concentration estimation method according to the second embodiment will be described together with the description of the salt concentration estimation apparatus 200.

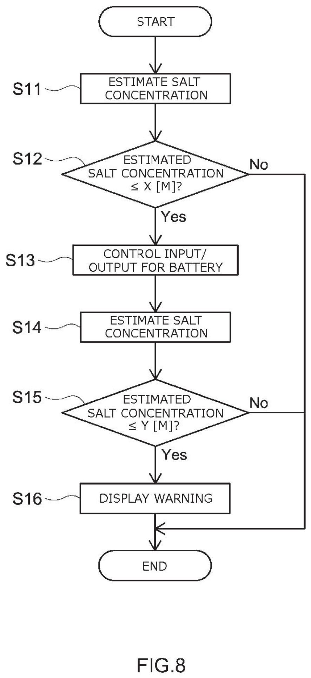

Herein, Fig. 8 is a flowchart illustrating the salt concentration estimation method in the electrolyte solution of the secondary battery 1 according to another embodiment (second embodiment). As illustrated in Fig. 8, the salt concentration estimation method according to the second embodiment first performs estimation of the salt concentration in the electrolyte solution of the secondary battery 1 (step S11). More specifically, a first capacity acquiring step, a first discharging time acquiring step, and a first salt concentration estimating step are performed. Herein, the first capacity acquiring step involves acquiring the capacity of the secondary battery 1 that is to be the estimation object. The first discharging time acquiring step involves acquiring the discharging time when the secondary battery 1 is discharged under predetermined conditions. The first salt concentration estimating step involves estimating the salt concentration in the electrolyte solution of the secondary battery 1 based on the acquired capacity of the secondary battery 1, the acquired discharging time, and a table that records a relationship between the capacity, the discharging time, and the salt concentration in the electrolyte solution of the secondary battery 1 related to the secondary battery 1 that is to be the estimation object.

In estimating the salt concentration, the capacity acquisition processing unit 120, the discharging time acquisition processing unit 121, and the salt concentration estimation processing unit 122 are operated in the salt concentration estimation apparatus 200 to thereby estimate the salt concentration in the electrolyte solution of the secondary battery 1. Note that for the details of the first capacity acquiring step, the first discharging time acquiring step, and the first salt concentration estimating step, reference may be made to the description in the foregoing first embodiment that describes the capacity acquiring step S1, the discharging time acquiring step S2, and the salt concentration estimating step S3.

Next, it is determined whether or not the salt concentration that is estimated in the first salt concentration estimating step is less than or equal to a predetermined salt concentration (X [M] herein) (step S12). That is, it is determined whether or not the salt concentration of the secondary battery 1 that is estimated in the first salt concentration estimating step is less than or equal to the predetermined salt concentration (first determining step).

In such a determination, the determination processing unit 123 in the salt concentration estimation apparatus 200 determines whether or not the salt concentration that is estimated by the salt concentration estimation processing unit 122 is less than or equal to the predetermined salt concentration. Then, if the salt concentration that is estimated by the salt concentration estimation processing unit 122 is not less than or equal to the predetermined salt concentration (i.e., if NO), the process flow ends. Alternatively, if the salt concentration that is estimated by the salt concentration estimation processing unit 122 is less than or equal to the predetermined concentration (i.e., if YES), the process flow proceeds to step S13.

Subsequently, the battery control values for the secondary battery 1 are controlled (step S13). That is, if it is determined that the salt concentration of the secondary battery 1 is lowered in the first determining step, the battery control values for the secondary battery 1 are controlled (controlling step). In such controlling, the control processing unit 125 in the salt concentration estimation apparatus 200 controls input/output values for the secondary battery 1. For example, by adjusting input/output values for the secondary battery **1,** it is possible to control the decrease rate of the salt in the electrolyte solution.

Next, for the secondary battery 1 having been subjected to the above-described input/output control, the salt concentration in the electrolyte solution is estimated (step S14). More specifically, a second capacity acquiring step, a second discharging time acquiring step, and a second salt concentration estimation step are performed. Herein, the second capacity acquiring step involves acquiring the capacity of the secondary battery 1 having been subject to the above-described control, which is the estimation object. The second discharging time acquiring step involves acquiring the discharging time when the secondary battery 1 having been subjected to the above-described control is discharged under predetermined conditions. The second salt concentration estimating step involves estimating the salt concentration in the electrolyte solution of the secondary battery 1 having been subjected to the above-described control, based on the acquired capacity of the secondary battery 1 having been subjected to the above-described control, the acquired discharging time after the above-described control, and a table that records a relationship between the capacity, the discharging time, and the salt concentration in the electrolyte solution of the secondary battery 1 related to the secondary battery 1 that is to be the estimation object. Specifically, based on the acquired capacity of the secondary battery 1 having been subjected to the above-described control and the acquired discharging time having been subjected to the above-described control, a table prepared in advance for the relationship between the capacity of the secondary battery 1, the discharging time of the secondary battery **1,** and the salt concentration in the electrolyte solution of the secondary battery 1 is referred to, to estimate the salt concentration in the electrolyte solution of the secondary battery 1 having been subjected to the above-described control. In such estimating of the salt concentration, the capacity acquisition processing unit 120, the discharging time acquisition processing unit 121, and the salt concentration estimation processing unit 122 are operated in the salt concentration estimation apparatus 200 to thereby estimate the salt concentration in the electrolyte solution of the secondary battery 1 having been subjected to the above-described control. Note that for the details of the second capacity acquiring step, the second discharging time acquiring step, and the second salt concentration estimating step, reference may be made to the description in the foregoing first embodiment that describes the capacity acquiring step S1, the discharging time acquiring step S2, and the salt concentration estimating step S3.

Subsequently, it is determined whether or not the salt concentration that is estimated in the second salt concentration estimating step is less than or equal to a predetermined salt concentration (Y [M] herein) (step S15). That is, it is determined whether or not the salt concentration of the secondary battery 1 that is estimated in the second salt concentration estimating step is less than or equal to the predetermined salt concentration (second determining step). In such a determination, the determination processing unit 123 in the salt concentration estimation apparatus 200 determines whether or not the salt concentration that is estimated by the salt concentration estimation processing unit 122 is less than or equal to the predetermined salt concentration. Then, if the salt concentration that is estimated by the salt concentration estimation processing unit 122 is not less than or equal to the predetermined salt concentration (i.e., if NO), the process flow ends. Alternatively, if the salt concentration that is estimated by the salt concentration estimation processing unit 122 is less than or equal to the predetermined concentration (i.e., if YES), the process flow proceeds to step S16.

Finally, if it is determined that the salt concentration of the secondary battery 1 having been subjected to the above-described control is lowered in the second determining step, a warning is displayed for the user (step S16). That is, if it is determined in the second determining step that the salt concentration in the electrolyte solution of the secondary battery 1 having been subjected to the above-described control is less than or equal to the predetermined salt concentration, the user is notified of the decrease of the salt concentration (notifying step). Such a notification to the user may be implemented by, for example, a display or a speaker equipped an electrically powered vehicle. In the present embodiment, a warning is displayed for the user on a display equipped in the electrically powered vehicle, as illustrated in Fig. 7.

It should be noted that the predetermined salt concentration X [M] in the step S12 (also referred to as a first salt concentration) and the predetermined salt concentration Y [M] in step S15 (also referred to as a second salt concentration) may be the same or may be different. However, from the viewpoint of more suitably preventing the decrease in the salt concentration in the electrolyte solution of the secondary battery 1, it is preferable that the second salt concentration be set higher than the first salt concentration. That is, it is preferable that the first salt concentration and the second salt concentration be set so as to satisfy the relation Second salt concentration > First salt concentration. It is preferable that the values of X and Y above be determined as appropriate depending on the type of the secondary battery 1, the environment in which the secondary battery 1 is placed, or the like.

The configuration as described above enables the user to be notified of a decrease in the salt concentration based on the estimation of the salt concentration in the electrolyte solution of the secondary battery 1. This may encourage the user to bring the electrically powered vehicle to the dealer for maintenance. Moreover, the decrease in the salt concentration may be dealt with by, for example, adjusting input/output values for the secondary battery 1.

Although the salt concentration estimation method according to the second embodiment includes a total of 10 steps, this is merely exemplary. The salt concentration estimation method disclosed herein may be configured to perform a total of 5 steps, the first capacity acquiring step, the first discharging time acquiring step, the first salt concentration estimating step, the first determining step, and the notifying step. When this is the case, the computer 110 of the salt concentration estimation apparatus may include the capacity acquisition processing unit 120, the discharging time acquisition processing unit 121, the salt concentration estimation processing unit 122, the determination processing unit 123, and the notification processing unit 124. Such a configuration enables the user to be notified of a decrease in the salt concentration based on the estimation of the salt concentration in the electrolyte solution of the secondary battery 1. This can prevent various problems that may occur in the secondary battery 1 such as described previously.

In addition, the salt concentration estimation method according to the second embodiment performs a total of 2 determinations, the first determining step and the second determining step, but this is merely exemplary. The salt concentration estimation method disclosed herein may perform the above-described controlling step again when the salt concentration in the electrolyte solution of the secondary battery 1 having been subjected to the above-described control is less than or equal to a predetermined salt concentration in the second determining step, and may perform the capacity acquiring step, the discharging time acquiring step, the salt concentration estimating step, and the discharging time. Such a configuration serves to adjust the salt concentration of the secondary battery 1 more accurately.

For example, although the foregoing embodiments describe the cases where the secondary battery 1 is mounted in an electrically powered vehicle, this is merely exemplary. The salt concentration estimation apparatus and the salt concentration estimation method disclosed herein may also target, for example, secondary batteries 1 placed in a facility or the like as the estimation object.

For example, although the foregoing embodiments use one secondary battery 1 as the estimation object, this is merely exemplary. The salt concentration estimation apparatus and the salt concentration estimation method disclosed herein may also target, for example, a battery pack (stack) including a plurality of secondary batteries 1 as the estimation object. However, the former is preferable from the viewpoint of estimating the salt concentration in the electrolyte solution of the secondary battery 1 more accurately.

Although the map shown in Fig. 3 shows the number of years of use in increments of 1 year in the range of 1 year to 10 years in the foregoing embodiments, for example, this is merely exemplary. The range of years of use and the number of increments may be changed as appropriate. In addition, although the map shown in Fig. 4 shows the charging time of the secondary battery 1 in increments of 1 minute in the range of 1 minute to 60 minutes, this is also merely exemplary. The range of charging time and the number of increments may be changed as appropriate. Moreover, the unit of temperature history, for example, may be expressed in "minutes", instead of "hours". Likewise, the unit of charging time, for example, may be expressed in "hours", instead of "minutes". The map shown in Fig. 3 may further contain other additional conditions.

Although the full charge capacity of the secondary battery 1 is calculated in percentage (%) in the foregoing embodiments, for example, this is merely exemplary. The full charge capacity of the secondary battery 1 may be calculated in actual numerical values (Ah) in other embodiments. In addition, for example, although the full charge capacity is measured as the capacity of the secondary battery 1 in the foregoing embodiments, this is merely exemplary. It is also possible that the technology disclosed herein may use a capacity measured under predetermined conditions as the capacity of the secondary battery 1.

Although the foregoing embodiments prepare a map showing the relationship between the capacity (full charge capacity herein), the discharging time (reach time herein), and the salt concentration of the secondary battery 1, for example, this is merely exemplary. The map may also contain other additional conditions in addition to these conditions.

As has been described above, the specific embodiments of the technology disclosed herein may include those set forth in the following items.

### Item 1:

A method of estimating a salt concentration in an electrolyte solution of a secondary battery, the method including:
a capacity acquiring step of acquiring a capacity of a secondary battery that is to be an estimation object;
a discharging time acquiring step of acquiring a discharging time when the secondary battery is discharged under a predetermined condition; and
a salt concentration estimating step of estimating the salt concentration in the electrolyte solution of the secondary battery based on the acquired capacity of the secondary battery, the acquired discharging time, and a table recording a relationship between the capacity, the discharging time, and the salt concentration in the electrolyte solution of the secondary battery, related to the secondary battery that is to be the estimation object.

### Item 2:

The method according to item 1, wherein:
the secondary battery is mounted in an electrically powered vehicle; and
in the discharging time acquiring step, the discharging time is acquired when the secondary battery is discharged under the predetermined condition during use of the electrically powered vehicle.

### Item 3:

The method according to item 1 or 2, wherein, in the discharging time acquiring step, the secondary battery is discharged with an SOC being at least 50% to acquire the discharging time.

### Item 4:

The method according to any one of items 1 to 3, wherein, in the discharging time acquiring step, the secondary battery is discharged under a temperature environment in which an average temperature is lower than or equal to -10°C to acquire the discharging time.

### Item 5:

An apparatus of estimating a salt concentration in an electrolyte solution of a secondary battery, the apparatus being configured to cause a computer to execute:
a capacity acquiring process of acquiring a capacity of a secondary battery that is to be an estimation object;
a discharging time acquiring process of acquiring a discharging time when the secondary battery is discharged under a predetermined condition; and
a salt concentration estimating process of estimating the salt concentration in the electrolyte solution of the secondary battery based on the acquired capacity of the secondary battery, the acquired discharging time, and a table recording a relationship between the capacity, the discharging time, and the salt concentration in the electrolyte solution of the secondary battery, related to the secondary battery that is to be the estimation object.

### Item 6:

The apparatus according to item 5, wherein:
the secondary battery is mounted in an electrically powered vehicle; and
in the discharging time acquiring process, the discharging time is acquired when the secondary battery is discharged under the predetermined condition during use of the electrically powered vehicle.

### Item 7:

The apparatus according to item 5 or 6, wherein, in the discharging time acquiring process, the secondary battery is discharged with an SOC being at least 50% to acquire the discharging time.

### Item 8:

The apparatus according to any one of items 5 to 7, wherein, in the discharging time acquiring process, the secondary battery is discharged under a temperature environment in which an average temperature is lower than or equal to -10°C to acquire the discharging time.

## Claims

1. A method of estimating a salt concentration in an electrolyte solution of a secondary battery (1), the method comprising:
a capacity acquiring step (S1) of acquiring a capacity of a secondary battery (1) that is to be an estimation object;
a discharging time acquiring step (S2) of acquiring a discharging time when the secondary battery (1) is discharged under a predetermined condition; and
a salt concentration estimating step (S3) of estimating the salt concentration in the electrolyte solution of the secondary battery (1) based on the acquired capacity of the secondary battery (1), the acquired discharging time, and a table recording a relationship between the capacity, the discharging time, and the salt concentration in the electrolyte solution of the secondary battery (1), related to the secondary battery (1) that is to be the estimation object.

2. The method according to claim 1, wherein:
the secondary battery (1) is mounted in an electrically powered vehicle; and
in the discharging time acquiring step (S2), the discharging time is acquired when the secondary battery (1) is discharged under the predetermined condition during use of the electrically powered vehicle.

3. The method according to claim 1 or 2, wherein, in the discharging time acquiring step (S2), the secondary battery (1) is discharged with an SOC being at least 50% to acquire the discharging time.

4. The method according to any one of claims 1 to 3, wherein, in the discharging time acquiring step (S2), the secondary battery (1) is discharged under a temperature environment in which an average temperature is lower than or equal to -10°C to acquire the discharging time.

5. An apparatus (100) of estimating a salt concentration in an electrolyte solution of a secondary battery (1), the apparatus being configured to cause a computer (10) to execute:
a capacity acquiring process (20) of acquiring a capacity of a secondary battery (1) that is to be an estimation object;
a discharging time acquiring process (21) of acquiring a discharging time when the secondary battery (1) is discharged under a predetermined condition; and
a salt concentration estimating process (22) of estimating the salt concentration in the electrolyte solution of the secondary battery (1) based on the acquired capacity of the secondary battery (1), the acquired discharging time, and a table recording a relationship between the capacity, the discharging time, and the salt concentration in the electrolyte solution of the secondary battery (1), related to the secondary battery (1) that is to be the estimation object.

6. The apparatus (100) according to claim 5, wherein:
the secondary battery (1) is mounted in an electrically powered vehicle; and
in the discharging time acquiring process (21), the discharging time is acquired when the secondary battery (1) is discharged under the predetermined condition during use of the electrically powered vehicle.

7. The apparatus (100) according to claim 5 or 6, wherein, in the discharging time acquiring process (20), the secondary battery (1) is discharged with an SOC being at least 50% to acquire the discharging time.

8. The apparatus (100) according to any one of claims 5 to 7, wherein, in the discharging time acquiring process (21), the secondary battery (1) is discharged under a temperature environment in which an average temperature is lower than or equal to -10°C to acquire the discharging time.
